# EUROPÄISCHE PATENTSCHRIFT

(11) **EP 2 671 264 B1**
(45) Veröffentlichungstag und Bekanntmachung des Hinweises auf die Patenterteilung: **03.01.2018**
(21) Anmeldenummer: 12701738.2
(22) Anmeldetag: 26.01.2012
(51) Int. Cl.: H01L 31/068

(54) **PHOTOVOLTAISCHE SOLARZELLE SOWIE VERFAHREN ZU DEREN HERSTELLUNG**
PHOTOVOLTAIC SOLAR CELL AND A METHOD FOR THE PRODUCTION OF SAME
CELLULE SOLAIRE PHOTOVOLTAÏQUE ET SON PROCÉDÉ DE FABRICATION

(30) Priorität: 01.02.2011 DE 102011010077
(43) Veröffentlichungstag der Anmeldung: 11.12.2013
(73) Patentinhaber: Fraunhofer-Gesellschaft zur Förderung der angewandten Forschung e.V., 80686 München (DE)
(72) Erfinder: THAIDIGSMANN, Benjamin, 79104 Freiburg (DE); CLEMENT, Florian, 79102 Freiburg (DE); WOLF, Andreas, 79100 Freiburg (DE); BIRO, Daniel, 79106 Freiburg (DE)
(74) Vertreter: Lemcke, Brommer & Partner Patentanwälte Partnerschaft mbB
(86) Internationale Anmeldenummer: PCT/EP2012/051243
(87) Internationale Veröffentlichungsnummer: WO 2012/104198

(56) Entgegenhaltungen:
- WO-A1-2010/049268
- WO-A2-2010/081505
- US-A1- 2008 078 439
- US-A1- 2009 260 684
- US-B1- 6 384 317
- B THAIDIGSMANN ET AL: "COMBINING THE ADVANTAGES OF WRAP THROUGH METALLIZATION AND REAR SURFACE PASSIVATION INTO INDUSTRIAL MWT-PERC DEVICES", 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6-10 SEPTEMBER 2010, VALENCIA, SPAIN, 1. Januar 2010 (2010-01-01), Seiten 2227-2230, XP055051030, ISBN: 978-3-93-633826-3
- TOBIAS FELLMETH ET AL: "19.5% EFFICIENT SCREEN PRINTED CRYSTALLINE SILICON METAL WRAP THROUGH (MWT) SOLAR CELLS FOR CONCENTRATOR (2-25x) APPLICATIONS", AIP CONFERENCE PROCEEDINGS, 1. Januar 2010 (2010-01-01), Seiten 47-52, XP055024307, ISSN: 0094-243X, DOI: 10.1063/1.3509230
- MACK S ET AL: "Towards 19% efficient industrial PERC devices using simultaneous front emitter and rear surface passivation by thermal oxidation", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20. Juni 2010 (2010-06-20), Seiten 34-38, XP031783873, ISBN: 978-1-4244-5890-5

## Beschreibung

Die Erfindung betrifft eine photovoltaische Solarzelle zur Umwandlung einfallender elektromagnetischer Strahlung in elektrische Energie gemäß Oberbegriff des Anspruchs 1 sowie ein Verfahren zu deren Herstellung gemäß Oberbegriff des Anspruchs 6. Eine photovoltaische Solarzelle stellt ein flächiges Halbleiterbauelement dar, bei dem mittels einfallender elektromagnetischer Strahlung Ladungsträgerpaare erzeugt und anschließend getrennt werden, so dass zwischen mindestens zwei metallischen Kontaktierungsstrukturen der Solarzelle ein Potential entsteht und über einen mit diesen Kontaktierungsstrukturen verbundenen externen Stromkreis elektrische Leistung von der Solarzelle abgegriffen werden kann. Die Ladungsträgertrennung erfolgt an einem pn-Übergang, der beispielsweise dadurch realisiert werden kann, dass in einem Siliziumsubstrat eines Basisdotierungstyps eine Dotierung eines hierzu entgegengesetzten Dotierungstyps zur Ausbildung eines Emitters vorgenommen wird. Ebenso ist es bekannt, den Emitter durch Aufbringen einer oder mehrerer Schichten auf einem Basissubstrat auszubilden.
Die vorliegende Erfindung betrifft eine Solarzelle und ein Verfahren zu deren Herstellung, wobei zumindest die Basis in einem Siliziumsubstrat ausgebildet ist, die Solarzelle somit eine Silizium-Solarzelle ist.
Zur Umwandlung einfallender elektromagnetischer Strahlung in elektrische Energie werden Module verwendet, welche eine Vielzahl von photovoltaischen Solarzellen umfassen. Bei dem Einbau in ein photovoltaisches Modul werden die Solarzellen in Reihenschaltung zu so genannten Strings zusammengesetzt. Ein Modul umfasst typischerweise mehrere Strings. Bei Betrieb eines solchen Moduls kann sich folgende Problematik ergeben:
Unter bestimmten Umständen wird bei dem Betrieb des Moduls ein Teil der enthaltenen Solarzellen abgeschattet, beispielsweise durch Laub oder andere Gegenstände, die sich zwischen Lichtquelle (typischerweise die Sonne) und Solarzelle befinden. Der von einer Solarzelle erzeugte Strom ist von der Beleuchtungsstärke abhängig, mit der die jeweilige Solarzelle beaufschlagt wird. Wird nun ein Teil der in Reihe geschalteten Solarzellen in einem String teilweise oder vollständig abgeschattet, kann eine Umkehrung der Polarität dieser abgeschatteten Solarzellen auftreten, da die erzeugte Stromstärke dieser Solarzellen geringer ist als die der vollständig beleuchteten Solarzellen.

Die abgeschatteten Solarzellen werden in diesem Fall in Sperrrichtung betrieben, d. h. an diesen Solarzellen liegt an den metallischen Kontaktierungen eine Spannung in Sperrrichtung an, die eine umgekehrte Polarität verglichen mit der bei nicht abgeschatteten Solarzellen an den metallischen Kontaktierungen anliegenden Spannung aufweist. Die Stromstärke des gesamten Strings, in dem sich die ganz oder teilweise abgeschatteten Solarzellen befinden, und damit die erzeugte elektrische Leistung dieses Strings, wird durch die Abschattung stark verringert.

Hierbei und im Folgenden wird als negative Spannung oder in Sperrrichtung anliegende Spannung wie üblich der Zustand bezeichnet, dass an den metallischen Kontaktierungen einer Solarzelle eine Spannung und/oder ein Stromfluss entgegengesetzt zu der Spannung und/oder dem Stromfluss in normalem Betrieb vorliegt. Die Spannung und der Stromfluss in normalem (insbesondere unabgeschattetem) Betrieb werden wie üblich als positive Spannung oder Spannung in Vorwärtsrichtung bezeichnet.

Je nach Aufbau des Moduls und der Art der Abschattung kann an die an den abgeschatteten Solarzellen anliegende negative Spannung sehr groß werden und zu einem unkontrollierten Durchbruch in Sperrrichtung an der oder den abgeschatteten Solarzellen führen. Hierbei wird elektrische Energie in den in Sperrrichtung betriebenen Solarzellen in Wärme umgewandelt. Dies kann zu einer Beschädigung des Moduls führen. Eine Beschädigung tritt typischerweise auf, wenn der in Sperrrichtung fließende Strom nicht flächig über die gesamte Fläche der Solarzelle oder zumindest eine große Fläche der Solarzelle fließt, sondern lediglich über lokale Bereiche der Solarzelle, die entsprechend eine hohe Stromdichte aufweisen und sich stark erhitzen (so genannte "Hot-Spots"). Insbesondere an solchen Hot-Spots kann aufgrund der großen Wärmeentwicklung die Solarzelle und/oder das Modul zerstört werden.

Bei der Herstellung von Solarzellenmodulen werden deshalb üblicherweise Bypassdioden angeordnet, welche elektrisch parallel zu den Strings verschaltet sind. Die Bypassdioden begrenzen die maximale Spannung in Sperrrichtung auf die Gesamtspannung eines Strings. Je kleiner die Anzahl an Zellen in einem String, desto kleiner ist die maximale Spannung, die an abgeschatteten Solarzellen in Sperrrichtung anliegen kann, so dass die Gefahr eines Durchbruchs und auch eines Leistungsverlustes bei Teilabschattung sinkt.

Um einen hohen Modulwirkungsgrad auch im Falle einer Teilabschattung des Moduls zu erzielen, wäre es daher optimal, jeder Solarzelle eine Bypassdiode elektrisch parallel zu schalten, so dass im Modul theoretisch eine Stringgröße von einer Solarzelle vorliegt. Aufgrund des hohen Herstellungsaufwandes und den entsprechend hohen Herstellungskosten ist dies jedoch nicht praktikabel.

Es ist daher bekannt, Dioden als eigenständige elektronische Bauteile innerhalb der Solarzelle auszubilden und entsprechend die positiven und negativen metallischen Kontakte der Solarzelle über diese Bypassdioden zu verschalten. Solche Solarzellen werden in US 5,616,185 und WO 2010/029180 A1 beschrieben. Nachteilig hierbei ist, dass bei der Solarzellenherstellung erhebliche zusätzliche Verfahrensschritte, insbesondere Diffusionsschritte zur Herstellung der Bypassdiode in einem Halbleitersubstrat der Solarzelle notwendig sind. Entsprechend ergeben sich erheblich erhöhte Herstellungskosten für solche Solarzellen.

Eine Solarzelle mit einer Rückseitenpassivierung und eine von der Vorder- zur Rückseite reichenden Durchmetallisierung zur rückseitigen Kontaktierung eines an der Vorderseite angeordneten Emitters ist aus B THAIDIGSMANN ET AL: "COMBINING THE ADVANTAGES OF WRAP THROUGH METALLIZATION ÄND REAR SURFACE PASSIVATION INTO INDUSTRIAL MWT-PERC DEVICES", 25TH EUROPEAN PHOTOVOLTAIC SOLAR ENERGY CONFERENCE ÄND EXHIBITION / 5TH WORLD CONFERENCE ON PHOTOVOLTAIC ENERGY CONVERSION, 6-10 SEPTEMBER 2010, VALENCIA, SPAIN, 1. Januar 2010, Seiten 2227-2230, ISBN: 978-3-93-633826-3 bekannt.

Der vorliegenden Erfindung liegt daher die Aufgabe zugrunde, eine photovoltaische Solarzelle und ein Verfahren zu deren Herstellung zu schaffen, um die Funktionalität einer Bypassdiode inhärent in einer Solarzelle auszubilden ohne dass hierdurch erhebliche Steigerungen der Prozesskomplexität bei der Herstellung und damit der Herstellungskosten auftreten.
Gelöst ist diese Aufgabe durch eine photovoltaische Solarzelle gemäß Anspruch 1 sowie ein Verfahren zur Herstellung einer photovoltaischen Solarzelle gemäß Anspruch 6. Vorzugsweise Ausführungsformen der erfindungsgemäßen Solarzelle finden sich in den Ansprüchen 2 bis 5; vorzugsweise Ausführungsformen des erfindungsgemäßen Verfahrens finden sich in den Ansprüchen 6 bis 12. Hiermit wird der Wortlaut der Ansprüche durch ausdrückliche Bezugnahme in die Beschreibung aufgenommen.
Die erfindungsgemäße photovoltaische Solarzelle ist zur Umwandlung einfallender elektromagnetischer Strahlung in elektrische Energie ausgebildet. Die Solarzelle umfasst mindestens einen in einem Siliziumsubstrat ausgebildeten Basisbereich eines Basisdotierungstyps und mindestens einen Emitterbereich eines Emitterdotierungstyps. Der Emitterdotierungstyp ist dem Basisdotierungstyp entgegengesetzt. Dotierungstypen sind hierbei die n-Dotierung und die hierzu entgegengesetzte p-Dotierung.
Die Solarzelle umfasst weiterhin mindestens eine metallische Basiskontaktierungsstruktur, welche Basiskontaktierungsstruktur elektrisch leitend mit dem Basisbereich verbunden ist und mindestens eine metallische Emitterkontaktierungsstruktur, welche Emitterkontaktierungsstruktur elektrisch leitend mit dem Emitterbereich verbunden ist.
Basisbereich und Emitterbereich sind dabei derart angeordnet, dass sich zumindest bereichsweise zwischen Basis und Emitterbereich ein pn-Übergang ausbildet.
Es liegt hierbei im Rahmen der Erfindung, dass der Emitterbereich in dem Siliziumsubstrat insbesondere mittels Diffusion ausgebildet ist. Ebenso liegt die Ausbildung des Emitters als Schicht, welche an dem Siliziumsubstrat, gegebenenfalls unter Zwischenschaltung weiterer Zwischenschichten, angeordnet ist, im Rahmen der Erfindung. Weiterhin liegt die Ausbildung des pn-Übergangs als pin-Übergang, d. h. unter Zwischenschaltung einer intrinsisch dotierten Schicht im Rahmen der Erfindung.
Emitter- und Basiskontaktierungsstruktur können dabei an Vorder- und/oder Rückseite der Solarzelle angeordnet sein. Insbesondere liegt es im Rahmen der Erfindung, die Basiskontaktierungsstruktur auf einer gegenüberliegenden Seite oder auf der gleichen Seite wie die Emitterkontaktierungsstruktur anzuordnen. Wesentlich ist, dass bei der erfindungsgemäßen photovoltaischen Solarzelle in einem Emitterbypassbereich die Emitterkontaktierungsstruktur den Basisbereich überlappend ausgebildet ist und in diesem Überlappungsbereich zumindest in einem Teilbereich, vorzugsweise im gesamten Überlappungsbereich ein diodenartiger Halbleiterkontakt zwischen Emitterkontaktierungsstruktur und Basisbereich ausgebildet ist. Der Halbleiterkontakt ist als Metall-Halbleiterkontakt, als Schottky-Kontakt ausgebildet.
Die erfindungsgemäße photovoltaische Solarzelle umfasst somit mindestens einen Überlappungsbereich, in welchem Überlappungsbereich ein diodenartiger Halbleiterkontakt ausgebildet ist. Dieser Halbleiterkontakt kann zwischen Emitterkontaktierungsstruktur und Basisbereich. Ebenso liegt es im Rahmen der Erfindung, dass die Solarzelle mehrere Überlappungsbereiche umfasst, in denen jeweils ein diodenartiger Halbleiterkontakt ausgebildet ist zwischen Emitterkontaktierungsstruktur und Basisbereich.
Die erfindungsgemäße Solarzelle weist somit mindestens einen diodenartigen Halbleiterkontakt auf, der eine Kontaktierungsstruktur mit einem artfremden Halbleiterbereich der Solarzelle über einen diodenartigen elektrischen Kontakt verbindet. Mittels des diodenartigen Halbleiterkontakts ist somit die Funktionalität einer Bypassdiode gegeben, wobei im Gegensatz zu vorbekannten Solarzellen jedoch nicht eine separate Diode ausgebildet ist, sondern der diodenartige Kontakt zwischen metallischer Kontaktierungsstruktur und Emitter- bzw. Basisbereich der Solarzelle besteht.

Der Erfindung liegt die Erkenntnis des Anmelders zugrunde, dass durch Ausbildung der vorgenannten diodenartigen Halbleiterkontakte in den Überlappungsbereichen in einfacher und kostengünstiger Weise die Funktionalität einer Bypassdiode erzielt wird. Insbesondere ist bei Verwendung der erfindungsgemäßen Solarzelle in einem Modul keine zusätzliche Verwendung einer Bypassdiode notwendig. Ebenso kann auf die aufwändige Ausbildung einer diodenartigen Struktur innerhalb der Solarzelle mittels zusätzlicher Diffusionen verzichtet werden.
Mittels der erfindungsgemäßen Solarzelle ist somit ein Solarzellenmodul herstellbar, welches eine erhöhte Effizienz durch die Bypassfunktionalität jeder einzelnen Solarzelle in diesem Modul aufweist.
Das erfindungsgemäße Verfahren zur Herstellung einer photovoltaischen Solarzelle umfasst folgende Verfahrensschritte:
Ein Siliziumsubstrat mit einem in dem Siliziumsubstrat ausgebildeten Basisbereich eines Basisdotierungstyps wird bereitgestellt.
Ein Emitterbereich wird in oder an dem Siliziumsubstrat ausgebildet. Der Emitterbereich weist einen Emitterdotierungstyp auf, welcher dem Basisdotierungstyp entgegengesetzt ist. Der Emitterbereich wird derart ausgebildet und/oder angeordnet, dass sich zwischen Basis- und Emitterbereich zumindest in Teilbereichen ein pn-Übergang ausbildet.
Eine metallische Basiskontaktierungsstruktur wird aufgebracht, welche elektrisch leitend mit dem Basisbereich verbunden ist.
Eine metallische Emitterkontaktierungsstruktur wird aufgebracht, welche elektrisch leitend mit dem Emitter verbunden ist.
Wesentlich ist, dass in einem Emitterbypassbereich die Emitterkontaktierungsstruktur den Basisbereich überlappend aufgebracht wird und in diesem Überlappungsbereich zumindest in einem Teilbereich, vorzugsweise im gesamten Überlappungsbereich ein diodenartiger Schottky-Kontakt zwischen Emitterkontaktierungsstruktur und Basisbereich ausgebildet wird.

Das erfindungsgemäße Verfahren weist die vorgenannten Vorteile auf, dass mit nur geringfügig erhöhter Prozesskomplexität und damit nur geringfügig erhöhten Herstellungskosten eine Solarzelle mit zusätzlicher Funktionalität einer Bypassdiode hergestellt wird.

Die erfindungsgemäße Solarzelle ist vorzugsweise mittels des erfindungsgemäßen Verfahrens oder einer vorzugsweisen Ausführungsform hiervon ausgebildet. Das erfindungsgemäße Verfahren ist vorzugsweise zur Herstellung der erfindungsgemäßen Solarzelle oder einer vorzugsweisen Ausführungsform hiervon ausgebildet.

Die erfindungsgemäße Solarzelle kann somit in an sich bekannter Weise in einem Solarzellemodul verschaltet werden, ohne dass die zusätzliche Funktionalität der Bypassdiode bei der Modulherstellung berücksichtig werden muss. Zusätzlich kann auf eine externe Bypassdiode verzichtet werden. Tritt nun im Betrieb die eingangs erwähnte Situation beispielsweise einer Teilabschattung auf, so dass eine oder mehrere Solarzellen innerhalb eines Strings in Rückwärtsrichtung betrieben werden, d. h. dass an diesen Solarzellen eine Spannung in Rückwärtsrichtung anliegt, so führt der diodenartige Halbleiterkontakt in dem Überlappungsbereich zu einem kontrollierten Durchbruch. Dies bedeutet, dass bei Anliegen einer Rückwärtsspannung zumindest ab einer gewissen Grenzspannung ein vorgegebener Mindeststromfluss in Rückwärtsrichtung über den diodenartigen Halbleiterkontakt fließt. Hierdurch wird einerseits ein zu hoher Spannungsaufbau in Rückwärtsrichtung vermieden und andererseits durch den kontrollierten Stromfluss im Überlappungsbereich an dem diodenartigen Halbleiterkontakt wird das Auftreten von vorgenannten Hot-Spots ebenfalls unterbunden.

Untersuchungen des Anmelders haben ergeben, dass in der Regel die vorgenannten negativen Effekte insbesondere durch Teilabschattung unterbunden werden, wenn eine Stromleitung in Rückwärtsrichtung ab einer an der Solarzelle anliegenden Rückwärtsspannung betragsmäßig größer 5 V, bevorzugt betragsmäßig größer 3 Volt erfolgt. Die Solarzelle ist daher vorzugsweise derart ausgebildet, dass der diodenartige Halbleiterkontakt in den Überlappungsbereich zumindest bei einer an den metallischen Kontaktstrukturen anliegenden Rückwärtsspannung betragsmäßig größer 5 V, vorzugsweise betragsmäßig größer 3 V in Rückwärtsrichtung elektrisch leitend ausgebildet ist. Die hier und im Folgenden verwendeten Begriffe "elektrisch leitend" und "elektrisch sperrend" werden wie bei der Beschreibung von Dioden üblich verwendet.

Untersuchungen des Anmelders haben weiterhin ergeben, dass vorzugsweise bei den zuvor angegebenen Grenzen für die Rückwärtsspannung mindestens eine elektrische Stromleitung in Sperrrichtung mit einer Stromflussdichte größer 100 mA/cm², bevorzugt größer 500 mA/cm², weiter bevorzugt größer 2000 mA/cm² erfolgt. Durch eine derartige Ausbildung des diodenartigen Halbleiterkontakts ist eine ausreichende Stromleitung in Rückwärtsrichtung insbesondere zur Vermeidung von Hot-Spots gewährleistet.

Die hierbei und im Folgenden angegebenen Stromflussdichten beziehen sich jeweils auf die die Fläche des Emitterbypassdiodenbereichs, vorzugsweise auf die Fläche des jeweiligen Überlappungsbereiches.

Der diodenartige Halbleiterkontakt im Überlappungsbereich führt wie zuvor beschrieben bei Anliegen einer Rückwärtsspannung zu einem kontrollierten Stromfluss in Rückwärtsrichtung, zumindest, sofern die Rückwärtsspannung betragsmäßig einen Grenzwert überschreitet. In Vorwärtsrichtung, d. h. bei Normalbetrieb der Solarzelle und entsprechend Anliegen einer Spannung in Vorwärtsrichtung an den metallischen Kontaktierungsstrukturen der Solarzelle ist es wünschenswert, dass der diodenartige Halbleiterkontakt im Überlappungsbereich die Solarzellencharakteristik nicht oder nur unwesentlich beeinflusst und insbesondere zu keiner oder nur einer geringfügigen Wirkungsgradverringerung führt.

Vorzugsweise ist der diodenartige Halbleiterkontakt bei Anliegen einer Vorwärtsspannung, d. h. im Normalbetrieb der Solarzelle elektrisch sperrend ausgebildet, so dass im Überlappungsbereich kein Stromfluss in Vorwärtsrichtung zwischen Basiskontaktierungsstruktur und Emitterbereich bzw. zwischen Emitterkontaktierungsstruktur und Basisbereich erfolgt.

Untersuchungen des Anmelders haben ergeben, dass in der Praxis bei hohen in Vorwärtsrichtung anliegenden Spannungen aufgrund der Ausgestaltung des Halbleiterkontakts im Überlappungsbereich typischerweise ein Stromfluss erfolgt. Wesentlich ist, dass in den bei Betrieb der Solarzelle relevanten Spannungsbereichen bei Anliegen einer Vorwärtsspannung kein oder nur ein geringer Stromfluss erfolgt.

Die erfindungsgemäße Solarzelle ist vorzugsweise daher derart ausgebildet, dass der diodenartige Halbleiterkontakt bei einer an den metallischen Kontaktstrukturen anliegenden Vorwärtsspannung im Bereich 0 V bis 0,5 V, vorzugsweise 0 V bis 0,6 V elektrisch sperrend ausgebildet ist. Insbesondere ist der diodenartige Halbleiterkontakt vorzugsweise derart ausgebildet, dass in dem genannten Spannungsbereich ein Stromfluss kleiner 10 mA/cm², bevorzugt kleiner 1 mA/cm², weiter bevorzugt kleiner 0,1 mA/cm² erfolgt.

Zur Vermeidung einer lokal hohen Wärmeentwicklung bei Stromfluss in Rückwärtsrichtung an den Überlappungsbereichen und insbesondere zur Vermeidung der Ausbildung von Hot-Spots und einer entsprechenden Schädigung der Solarzelle und/oder des Solarzellenmoduls ist es vorteilhaft, dass bei der erfindungsgemäßen Solarzelle ein oder mehrere Überlappungsbereiche ausgebildet sind und die Gesamtfläche des oder der Überlappungsbereiche größer 0,5 %, bevorzugt größer 2 %, weiter bevorzugt größer 5 % der Gesamtfläche der Solarzelle ist. Hierbei bezieht sich der Begriff "Gesamtfläche der Solarzelle" auf die übliche Definition der Solarzellenfläche, d. h. beispielsweise die Fläche der im Betrieb der Solarzelle dem Sonnenlicht zugewandten Seite.

Es liegt im Rahmen der Erfindung, dass im Überlappungsbereich ein Metall-Halbleiterkontakt ausgebildet ist. Ebenso liegt es im Rahmen der Erfindung, dass im Überlappungsbereich zusätzlich ein Metall-Isolator-Halbleiterkontakt ausgebildet ist.

Untersuchungen des Anmelders haben ergeben, dass die Ausbildung von Teilbereichen des Überlappungsbereiches als Metall-Isolator-Halbleiterkontakt Vorteile aufweist, da ein solcher Kontakt eine bessere elektrische Sperrwirkung bei Anliegen einer Vorwärtsspannung aufweist.

Vorzugsweise ist bei der erfindungsgemäßen Solarzelle daher in einem Teilbereich des Überlappungsbereiches ein diodenartiger Metall-Isolator-Halbleiterkontakt ausgebildet, in dem zwischen metallischer Kontaktierungsstruktur und Halbleiter eine Isolierungsschicht angeordnet ist.

Die Isolierungsschicht bedeckt vorzugsweise mehr als 50%, weiter bevorzugt mehr als 90% des Überlappungsbereiches.

Vorzugsweise weist die Isolierungsschicht eine Dicke kleiner 500 nm, insbesondere kleiner 200 nm, vorzugsweise kleiner 150 nm auf. Weiterhin ist es vorteilhaft, dass die Isolierungsschicht eine Dicke größer 10 nm, vorzugsweise größer 50 nm aufweist. Diese Wertebereiche für die Dicke der Isolierungsschicht ergeben eine Optimierung einerseits hinsichtlich der elektrischen Sperrwirkung bei Anliegen einer Spannung in Vorwärtsrichtung und andererseits einem ausreichenden Stromfluss bei Anliegen einer Spannung in Rückwärtsrichtung, zumindest bei einer Spannung betragsmäßig größer einer Grenzspannung.

Die Isolierungsschicht ist vorzugsweise eine Siliziumnitridsschicht, eine Aluminiumoxidschicht oder eine Siliziumoxidschicht. Ebenso liegt die Verwendung eines Schichtsystems zwischen Halbleiter und metallischer Kontaktstruktur im Rahmen der Erfindung.

Zwar lässt sich durch das Aufbringen einer Metallschicht auf eine elektrisch isolierende Schicht aufgrund der elektrisch isolierenden Wirkung kein Metall-Halbleiterkontakt mit diodenartigem Charakter herstellen, Untersuchungen des Anmelders haben jedoch gezeigt, dass bei typischen Herstellungsverfahren die Metallschicht die Isolierungsschicht bereichsweise, typischerweise punktweise durchdringt. Dies kann durch so genannte pinholes, insbesondere bei porösen elektrisch isolierenden Schichten und/oder durch ein durch punktartiges Durchgreifen der Metallschicht durch die Isolationsschicht hindurch bis zu der Halbleiterschicht erfolgen. Insbesondere bei den im folgenden erwähnten Verfahren, welche ein "Durchfeuern" der Kontakte beinhalten, d. h. einen Temperaturschritt, bei denen ein Metall-Halbleiterkontakt ausgebildet wird, kann sich trotz der Zwischenschaltung eine Isolierungsschicht, insbesondere mit einer Dicke im vorgenannten Bereich, ein diodenartiger Metall-Halbleiterkontakt ausbilden.

Es sind Verfahren zum Herstellen und Aufbringen metallischer Kontaktierungsstrukturen bekannt, bei denen Metallpasten verwendet werden, welche Fritte, typischerweise Glasfritte enthalten. Die Fritte erfüllt die Funktion, dass bei Kontaktherstellung, dem so genannten "Kontaktfeuern", d. h. dem Beaufschlagen der metallischen Kontaktierungsstruktur mit Wärme die Herstellung eines elektrischen Kontakts zwischen metallischer Kontaktierungsstruktur und Halbleiter durch die Fritte begünstigt wird. Insbesondere ist es möglich, dass eine zwischen Kontaktierungsstruktur und Halbleiter liegende Isolierungsschicht beim Kontaktfeuern durchdrungen wird, so dass trotz Vorhandensein der Isolierungsschicht ein elektrischer Kontakt erzeugt wird.

Im Überlappungsbereich ergaben Untersuchungen des Anmelders jedoch, dass ein zu hoher Anteil an Fritte in der Kontaktierungsstruktur im Überlappungsbereich nachteilig ist, da beim Kontaktfeuern ein Halbleiterkontakt entsteht, der die gewünschte zuvor beschriebene Sperrwirkung bei Anliegen einer Spannung in Vorwärtsrichtung nicht oder nur unzureichend aufweist.

Vorzugsweise weist bei der erfindungsgemäßen Solarzelle daher zumindest im Überlappungsbereich die metallische Kontaktstruktur einen Anteil an Glasfritte kleiner 5 %, bevorzugt kleiner 2 %, weiter bevorzugt 1 % auf. Insbesondere ist es vorteilhaft, dass zumindest im Überlappungsbereich die metallische Kontaktstruktur keine Glasfritte aufweist.

Wie zuvor beschrieben, dient die metallische Kontaktierungsstruktur im Falle der Ausbildung als Basiskontaktierungsstruktur zur elektrischen Kontaktierung des Basisbereichs und im Falle der Ausbildung als Emitterkontaktierungsstruktur zur elektrischen Kontaktierung des Emitterbereichs. Es liegt hierbei im Rahmen der Erfindung, dass die metallische Kontaktierungsstruktur einheitlich ausgebildet ist, d. h. sowohl außerhalb als auch innerhalb des Überlappungsbereichs eine einheitliche Zusammensetzung aufweist.

Ebenso liegt es im Rahmen der Erfindung, die Basiskontaktierungsstruktur mit einer im Überlappungsbereich unterschiedlichen Zusammensetzung auszubilden. Ebenso liegt es im Rahmen der Erfindung, die metallische Kontaktierungsstruktur mehrteilig auszubilden, beispielsweise indem ein erster Teil der Kontaktierungsstruktur mit einer ersten Ausbildung und insbesondere einer ersten stofflichen Zusammensetzung im Überlappungsbereich aufgebracht wird und mindestens ein zweiter Teil der Kontaktierungsstruktur mit einer zweiten Ausbildung und insbesondere zweiten stofflichen Zusammensetzung, welche gegenüber der ersten stofflichen Zusammensetzung unterschiedlich sein kann, in den Bereichen ausgebildet wird, in denen eine elektrische Kontaktierung des Basisbereichs erfolgen soll. Wesentlich ist, dass der erste und der zweite Teil der Kontaktierungsstruktur elektrisch leitend miteinander verbunden sind. Vorzugsweise sind erster und zweiter Teil der Kontaktierungsstruktur unmittelbar aneinander grenzend ausgebildet, so dass hierdurch die elektrisch leitende Verbindung zwischen den beiden Teilen der Kontaktierungsstruktur gegeben ist.

Untersuchungen des Anmelders haben weiterhin ergeben, dass es für die gewünschte Funktionalität einer Bypassdiode im Überlappungsbereich nachteilig ist, wenn die Dotierstoffkonzentration an der Oberfläche oder im Oberflächenbereich des Halbleiters im Überlappungsbereich an der der metallischen Kontaktierungsstruktur zugewandten Oberfläche zu hoch ist. Eine hohe Dotierung (d. h. eine hohe p-Dotierung oder hohe n-Dotierung) führt zu einer geringen Sperrwirkung bei Anliegen einer Vorwärtsspannung.

Vorzugsweise ist die erfindungsgemäße Solarzelle daher derart ausgeführt, dass im Überlappungsbereich die Dotierkonzentration im Halbleiter an der der metallischen Kontaktierungsstruktur zugewandten Oberfläche kleiner 10¹⁹ cm⁻³, bevorzugt kleiner 10¹⁸ cm⁻³, weiter bevorzugt kleiner 10¹⁷ cm⁻³ ist.

Die Ausbildung eines diodenartigen Halbleiterkontakts als Metall-Halbleiterkontakt und insbesondere als Schottky-Kontakt ist dem Fachmann grundsätzlich bekannt. Untersuchungen des Anmelders haben ergeben, dass für die Ausbildung eines Emitterbypassbereichs jeweils die Verwendung von Metallen aus einer bestimmten Gruppe vorteilhaft ist, da sich bei diesen Metallen in einfacher Weise der gewünschte diodenartige Halbleiterkontakt ausbilden lässt:
Insbesondere zur Ausbildung eines Schottky-Kontaktes ist dem Fachmann bekannt, dass nach der Theorie der Schottky-Kontakte die Austrittsarbeit des jeweiligen Dotierungstyps an der Halbleiteroberfläche im Überlappungsbereich und die Austrittsarbeit des Metalls, welche an die Halbleiteroberfläche im Überlappungsbereich angrenzt, wesentlich ist für die Eigenschaften des Kontakts.

Für die Kontakteigenschaften ist jeweils nur das Metall ausschlaggebend, das in direktem Kontakt zu Silizium steht, darauf aufbauende Schichtsysteme sind beliebig möglich.

Es ist daher vorteilhaft, dass in dem Emitterbypassbereich die Emitterkontaktierungsstruktur eines oder mehrere Metalle der Gruppe Silber, Aluminium, Titan, Palladium, Zink, Platin, Nickel, Zinn, Blei, Kobalt, Wolfram und Bismut umfasst.

Wie bereits beschrieben, zeichnet sich die erfindungsgemäße Solarzelle durch die zusätzliche Funktionalität einer Bypassdiode aus. Diese ist durch den diodenartigen Halbleiterkontakt im Überlappungsbereich gewährleistet. Die Funktionalität der Bypassdiode wird dadurch erzielt, dass bei Anliegen einer Spannung in Vorwärtsrichtung im Überlappungsbereich der diodenartige Halbleiterkontakt elektrisch sperrt, zumindest im Sinne der vorangehend angegebenen Bereiche für die Spannung und hinsichtlich des angegebenen maximalen Stromflusses. Weiterhin zeichnet sich die Funktionalität der Bypassdiode dadurch aus, dass bei Anliegen einer Spannung in Rückwärtsrichtung zumindest einer Spannung betragsmäßig größer einer wie zuvor angegebenen Grenzspannung der diodenartige Halbleiterkontakt im Überlappungsbereich elektrisch leitet, zumindest mit Stromdichten wie zuvor angegeben. Hierbei ist es irrelevant, ob in elektrotechnischer Hinsicht der diodenartige Halbleiterkontakt im Überlappungsbereich derart ausgebildet ist, dass im Ersatzschaltbild eine Diode in Vorwärtsrichtung oder in Rückwärtsrichtung angeordnet ist. Wesentlich ist, dass die zuvor genannte Funktionalität einer Bypassdiode mit den beschriebenen Mindestbedingungen an das elektrische Sperren und elektrische Leiten gewährleistet ist.

Es liegt im Rahmen der Erfindung, dass der diodenartige Halbleiterkontakt derart ausgebildet ist, dass das Diodenersatzschaltbild im Überlappungsbereich derart angeordnet ist, dass bei Anliegen einer Vorwärtsspannung (d. h. im typischen Betrieb der Solarzelle) an der im Ersatzschaltbild angenommenen Diode im Überlappungsbereich eine Spannung in Sperrrichtung anliegt und entsprechend bei Teilabschattung und Anliegen einer Rückwärtsspannung an der gesamten Solarzelle an der Diode angenommenen Diode im Ersatzschaltbild im Überlappungsbereich eine Vorwärtsspannung anliegt.

Ebenso liegt es jedoch im Rahmen der Erfindung, dass der diodenartige Halbleiterkontakt derart ausgebildet ist, dass die angenommene Diode im Ersatzschaltbild umgekehrt angeordnet ist, d. h. dass an dieser Diode im Normalbetrieb eine Vorwärtsspannung und bei Teilabschattung eine Rückwärtsspannung anliegt. Wesentlich ist hierbei, dass die Diodenkennlinie derart ausgebildet ist, dass die zuvor genannte Mindestfunktionalität hinsichtlich des elektrischen Leitens und Sperrens gewährleistet ist.

Insbesondere liegt es im Rahmen der Erfindung, dass im Überlappungsbereich der diodenartige Metall-Halbleiterkontakt mit einer an den metallischen Kontaktstrukturen anliegenden Vorwärtsspannung in Flussrichtung liegenden Diode (d. h. angenommenen Diode in einem Ersatzschaltbild) ausgebildet ist.

Die Oberflächen der Halbleiterschichten oder Halbleitersubstrate bei Solarzellen weisen häufig Texturen auf. Dies ist darin begründet, die Reflexion an der bei Betrieb der Solarzelle dem Lichteinfall zugewandten Seite der Solarzelle zu verringern, so dass ein höherer Anteil der einfallenden Photonen in die Solarzelle eingekoppelt wird. Ebenso ist es bekannt, mittels Texturen, die interne Reflexion zu erhöhen, so dass ein Austritt von bereits in die Solarzelle eingekoppelten Photonen aus dem Halbleitersubstrat oder der Halbleiterschicht verringert wird. Hierfür sind eine Vielzahl von Texturen bekannt, beispielsweise regelmäßige oder unregelmäßige Pyramidenstrukturen.

Untersuchungen des Anmelders haben ergeben, dass die Ausbildung des diodenartigen Halbleiterkontakts im Überlappungsbereich bei Vorliegen von Unebenheiten, insbesondere bei Vorliegen von Texturen kritisch ist. Dies ist darin begründet, dass aufgrund von Unebenheiten in einzelnen lokalen Bereichen unterschiedliche elektrische Bedingungen und/oder Schichtanordnungen auftreten können, so dass insbesondere das Risiko der Ausbildung eines ohmschen elektrischen Kontakts (und nicht des gewünschten diodenartigen Halbleiterkontakts) besteht.

Vorzugsweise ist die Halbleiteroberfläche bei der erfindungsgemäßen Solarzelle daher zumindest im Überlappungsbereich zumindest teilweise plan, vorzugsweise vollständig plan. Die Bezeichnung "plan" bezieht sich hierbei auf die Abwesenheit von Texturierungen, insbesondere auf eine mittlere Rauheit kleiner 5 µm.

Die Erfindung umfasst weiterhin ein Solarzellenmodul, welches eine oder mehrere Solarzellen gemäß einem der vorangegangenen Ansprüche umfasst. Die Solarzellen sind dabei in an sich bekannter Weise in Reihen- und/oder Parallelschaltungen miteinander elektrisch verbunden. Insbesondere liegt die an sich bekannte Reihenschaltung von Solarzellen in Strings und Parallelschaltung mehrerer solcher Strings in einem Solarzellenmodul im Rahmen der Erfindung.

Es ist dabei möglich, lediglich eine oder einen Teil der Solarzellen des Solarzellenmoduls gemäß der erfindungsgemäßen Solarzelle, umfassend mindestens einen diodenartigen Halbleiterkontakt in einem Überlappungsbereich auszubilden. Hierdurch ist zumindest an den Positionen dieser Solarzellen gewährleistet, dass die Funktionalität einer Bypassdiode besteht. So liegt es beispielsweise im Rahmen der Erfindung, in einem String eines Solarzellenmoduls lediglich einen Teil der Solarzellen gemäß der erfindungsgemäßen Solarzelle auszubilden und diese Solarzellen möglichst gleichmäßig in dem genannten String zu verteilen, insbesondere lediglich jede zweite, jede dritte oder jede vierte Solarzelle gemäß der erfindungsgemäßen Solarzelle mit einer Funktionalität einer Bypassdiode auszubilden. Vorzugsweise sind in dem erfindungsgemäßen Solarzellenmodul sämtliche Solarzellen gemäß einer erfindungsgemäßen Solarzelle ausgebildet.

Das erfindungsgemäße Solarzellenmodul weist vorzugsweise keine externe Bypassdiode auf, d. h. keine Bypassdiode, abgesehen von dem oder den integralen diodenartigen Halbleiterkontakten der Solarzellen gemäß der vorliegenden Erfindung. Hierdurch werden die Produktionskosten bei Herstellung des Solarzellenmoduls verringert.

Untersuchungen des Anmelders haben ergeben, dass die Ausbildung des diodenartigen Halbleiterkontakts in dem Überlappungsbereich grundsätzlich bei den vorbekannten Silizium-Solarzellenstrukturen möglich ist.

Besonders vorteilhaft ist die Ausbildung des erfindungsgemäßen Verfahrens zur Herstellung einer Solarzelle bei solchen Herstellungsverfahren, bei denen die metallische Kontaktierungsstruktur mittels Siebdruck aufgebracht wird. Vorzugsweise wird bei dem erfindungsgemäßen Verfahren zum Herstellen einer Solarzelle daher zumindest in dem Überlappungsbereich die Kontaktierungsstruktur mittels Siebdruck aufgebracht, vorzugsweise durch Aufbringen einer silberhaltigen Siebdruckpaste. Untersuchungen des Anmelders haben ergeben, dass bei dieser Art der Herstellung der Kontaktierungsstruktur in einfacher und unaufwändiger Weise ein diodenartiger Halbleiterkontakt im Überlappungsbereich hergestellt werden kann.

Die Siebdruckpaste bei vorgenannter vorzugsweiser Ausführungsform des Verfahrens enthält vorzugsweise Fritte mit einem Anteil im Bereich von 0,1 % bis 3 %, bevorzugt von 0,1 % bis 2 %. Hierdurch ist gewährleistet, dass einerseits in einem nachgelagerten Kontaktfeuerungsschritt der diodenartige Halbleiterkontakt erzeugt wird, andererseits jedoch der Anteil an Fritte gering genug ist, um das Erzeugen eines Ohmschen elektrischen Kontakts im Überlappungsbereich zu unterbinden. Insbesondere ist es vorteilhaft, dass die Siebdruckpaste Bleiglasfritte und/oder Zinkglasfritte und/oder Bismutglasfritte enthält. Der Anteil an Bleiglasfritte liegt dabei vorzugsweise unter 1 %.

Vorzugsweise enthält die Siebdruckpaste eines oder mehrere Oxide, insbesondere eines oder mehrere Oxide aus der Gruppe GeO₂, P₂O₅, Na₂O, K₂O, CaO, Al₂O₃, MgO, TiO₂, B₂O₃.

Die Kontaktausbildung wird, wie zuvor beschrieben, vorzugsweise durch einen Kontaktfeuerschritt gewährleistet. Insbesondere ist es vorteilhaft, bei der Solarzellenherstellung die aufgebrachte Siebdruckpaste einer Temperatur im Bereich 500 °C bis 1000 °C, bevorzugt im Bereich 700 °C bis 900 °C auszusetzen. Die Temperatureinwirkung erfolgt bevorzugt über eine Zeitspanne von 1 s bis 10 s.

Insbesondere die vorteilhafte Ausgestaltung des erfindungsgemäßen Verfahrens, bei dem der diodenartige Halbleiterkontakt im Überlappungsbereich in einem an sich bekannten Siebdruckverfahren durch Aufbringen einer Siebdruckpaste, vorzugsweise einer silberhaltigen Siebdruckpaste erzeugt wird, zeigt, dass durch geringen Zusatzaufwand das erfindungsgemäße Verfahren in bereits in der industriellen Fertigung bestehende Herstellungsverfahren für Solarzellen integrierbar ist. Beispielsweise kann bei Herstellen einer Solarzelle mit diffundiertem Emitter lediglich ein Bereich der Solarzellenoberfläche bei der Emitterdiffusion ausgespart werden, so dass in diesem Aussparungsbereich die Basisdotierung des Basisdotierungstyps vorliegt. Bei der Aufbringung der metallischen Emitterkontaktierungsstruktur wird, wie an sich bekannt, der Emitter in den entsprechenden Bereichen mit Siebdruckpaste belegt, zusätzlich werden in diesem Fall auch die zuvor ausgesparten Bereiche mit Siebdruckpaste belegt, d.h. Bereiche, in denen die Siebdruckpaste nun auf einem Halbleiter mit einer Basisdotierung des Basisdotierungstyps vorliegt.

In dem nachfolgenden Kontaktfeuerschritt wird nun einerseits in an sich bekannter Weise zwischen der metallischen Emitterkontaktierungsstruktur und dem diffundierten Emitter ein elektrischer Kontakt erzeugt. Gleichzeitig wird jedoch in den Bereichen, in denen kein Emitter diffundiert wurde, d. h. Überlappungsbereich im Sinne der vorliegenden Anmeldung, ein diodenartiger Halbleiterkontakt erzeugt, der die Funktionalität einer Bypassdiode gewährleistet.

Ebenso ist es möglich, dass der Emitter zunächst in an sich bekannter Weise aufgebracht wird und anschließend in den Bereichen, in denen Überlappungsbereiche und entsprechend diodenartige Halbleiterkontakte ausgebildet werden sollen, der Emitter wieder entfernt wird, beispielsweise durch Rückätzen des Halbleiters.

Die Ausbildung der Überlappungsbereiche und des diodenartigen Halbleiterkontakts in diesen Überlappungsbereichen ist grundsätzlich bei den typischen an sich bekannten Solarzellenstrukturen möglich, insbesondere auch bei Metal-Wrap-Through- bzw. MWT-Solarzellen, deren Struktur beispielsweise in US 6,384,317 B1 beschrieben ist oder bei Emitter-Wrap-Through- bzw. EWT-Solarzellen, deren Struktur beispielsweise in ("Emitter wrap-through solar cell", Gee, 1993, DOI: 10.1109/PVSC.1993.347173) beschrieben ist.

Wie zuvor beschrieben, ist es vorteilhaft, bei dem erfindungsgemäßen Verfahren zumindest im Überlappungsbereich die Kontaktierungsstruktur mittels Siebdruck aufzubringen. Ebenso liegen andere Verfahren zum Aufbringen der Kontaktierungsstruktur im Rahmen der Erfindung, insbesondere das Aufbringen mittels kontaktloser Druckverfahren, vorzugsweise Inkjetdruck oder Aerosoldruck. Ebenso liegt das Aufbringen der Kontaktierungsstruktur mittels physikalischer Gasphasenabscheidung, vorzugsweise mittels Bedampfen, im Rahmen der Erfindung.

Es liegt im Rahmen der Erfindung, den Überlappungsbereich bei der erfindungsgemäßen Solarzelle an der in Betrieb dem Lichteinfall zugewandten Seite der Solarzelle, an der dieser Seite abgewandten Rückseite der Solarzelle oder mehrere Überlappungsbereiche an beiden Seite anzuordnen.

Insbesondere ist es jedoch vorteilhaft, den Überlappungsbereich an der Rückseite, d. h. in Betrieb der Solarzelle dem Lichteinfall abgewandten Seite der Solarzelle anzuordnen, da hier beispielsweise eine Texturierung im Gegensatz zu der Vorderseite nicht zwingend nötig ist und somit der Überlappungsbereich plan ausgestaltet werden kann. Untersuchungen des Anmelders haben gezeigt, dass insbesondere vorgenannte MWT-Solarzellenstruktur zur Ausbildung als erfindungsgemäße Solarzelle geeignet ist, insbesondere, in dem an der rückseitigen Emittermetallisierung Überlappungsbereiche mit einem diodenartig ausgebildeten Metall-Halbleiterkontakt ausgebildet sind. Denn insbesondere bei solch einer MWT-Solarzelle kann durch geringfügiges Erweitern der Verfahrensschritte bei dem Herstellungsverfahren eine erfindungsgemäße Solarzelle mit Funktionalität einer Bypassdiode erzeugt werden.

Weitere Vorteile und Eigenschaften der vorliegenden Erfindung werden im Folgenden anhand von Ausführungsbeispielen und den Figuren erläutert:
Dabei zeigt:
   - Figur 1: das Ergebnis einer Strom-Spannungsmessung an Teststrukturen mit einem diodenartigen Halbleiterkontakt für unterschiedliche Anteile von Bleioxid in der Siebdruckpaste;
   - Figur 2: eine schematische Darstellung eines Teilausschnitts eines ersten Ausführungsbeispiels einer erfindungsgemäßen Solarzelle;
   - Figur 3: eine schematische Darstellung eines Teilausschnitts eines zweiten Ausführungsbeispiels einer erfindungsgemäßen Solarzelle;
   - Figur 4: eine schematische Darstellung eines Teilausschnitts eines dritten Ausführungsbeispiels einer Solarzelle, die nicht Teil der Erfindung ist;

   - Figur 5: eine schematische Darstellung eines Teilausschnitts einer Draufsicht auf eine Solarzelle gemäß Figur 2. Figur 2 stellt dabei einen Schnitt entlang der Schnittlinie A in Figur 5 und senkrecht zur Zeichenebene in Figur 5 da und
   - Figur 6: eine schematische Darstellung eines Teilausschnitts einer Rückansicht einer Solarzelle gemäß Figur 4.
In den Figuren bezeichnen gleiche Bezugszeichen gleiche Elemente.

Zur Verdeutlichung der grundsätzlichen Funktionalität einer Bypassdiode bei Erzeugung eines diodenartigen Halbleiterkontakts führte der Anmelder folgende Untersuchungen durch:
Es wurden Silber-Siebdruckpasten mit unterschiedlicher Bleioxid-Konzentration zur Herstellung einer metallischen Kontaktierungsstruktur verwendet. Die Kontaktierungsstrukturen wurden auf einem Siliziumsubstrat mit einer p-Basisdotierung im Bereich von 5x10¹¹ cm⁻³ bis 1,5x10¹⁶ cm⁻³ in aufgebracht. Hierbei wurden an sich bekannte, typische Verfahrensschritte zum Aufbringen einer metallischen Kontaktierungsstruktur mittels Silber-Siebdruckpaste bei Siliziumsolarzellen verwendet, wie beispielsweise in "Sonnenenergie: Photovoltaik" von Goetzberger, Voß, Knobloch, 2. Ausgabe, Teubner-Verlag Stuttgart bzw. US 4,235,644 beschrieben.

Das Verfahren umfasst folgende Verfahrensschritte: Entfernen des Sägeschadens an den Oberflächen der p-typ Wafer durch Ätzen in Kalilauge, Aufbringen einer SiNx-Schicht per PECVD (Plasma Enhanced Chemical Vapour Deposition) auf die mit Silber zu bedruckende Seite bei einem Teil der Wafer, Siebdruck der Ag-Paste (wie ein typisches Vorderseiten-Kontaktgitter), Siebdruck einer Al-Paste auf die gegenüberliegende Seite (zur Ausbildung einen ohmschen Kontakts) und Kontaktfeuern für wenige Sekunden bei 800 °C. Anschließend Messung der Kennlinien mit einem Industrie-Zelltester.

Kurve a) zeigt die Strom-Spannungskennlinie einer Versuchsstruktur, bei der eine Silberpaste mit einem Anteil Bleioxid kleiner 1 % verwendet wurde. Die Paste wurde unmittelbar auf die Halbleiteroberfläche aufgebracht und nach Kontaktfeuern zeigt sich bereits das gewünschte diodenartige Verhalten:
Bei Betrieb in Vorwärtsrichtung (positive Spannungswerte) weist die Struktur lediglich einen sehr geringen Stromfluss bis zu einer Spannung von etwa 0,8 V auf. Dies bedeutet, dass insbesondere im relevanten Spannungsbereich 0 V bis 0,6 V die Struktur als elektrisch sperrend bezeichnet werden kann. Sie weist in diesem Spannungsbereich einen Stromfluss mit einer Stromflussdichte kleiner 10 mA/cm² auf.

Bei Anliegen einer Spannung in Sperrrichtung, wie es beispielsweise einer Teilabschattung einer Solarzelle der Fall wäre, zeigt sich ein erheblicher Stromfluss ab für Spannungen kleiner -4,5 V (d.h. negative Spannungen betragsmäßig größer 4,5 V).

Zwar kann die Struktur im Spannungsbereich 0 V bis -4 V als elektrisch sperrend bezeichnet werden. Dies ist jedoch irrelevant, da bei Spannungsumkehr und insbesondere bei Teilabschattung von Solarzellen in einem String typischerweise Spannungen kleiner -5 V (d.h. negative Spannungen betragsmäßig größer 5 V) in Sperrrichtung an den abgeschatteten Solarzellen anliegen.

Bereits diese Teststruktur zeigt somit die Funktionalität einer Bypassdiode, indem sie in Vorwärtsrichtung zumindest im relevanten Spannungsbereich als elektrisch sperrend wirkt und in Rückwärtsrichtung zumindest bei Spannungen kleiner -4,5 V elektrisch leitend wirkt, so dass ein kontrollierter Durchbruch in Sperrrichtung erzeugt wird und insbesondere Hot-Spots vermieden werden.

Die mit b) gekennzeichnete Stromspannungskennlinie zeigt eine Versuchsstruktur, bei der die Silberpaste einen Anteil von Bleioxid größer 2,5 % aufweist. Zwar zeigt diese Struktur bei in Sperrrichtung anliegenden Spannungen (negativen Spannungen) ebenfalls die Funktionalität einer Bypassdiode. Bei Spannungen in Vorwärtsrichtung (positive Spannungen) zeigt diese Struktur insbesondere im relevanten Spannungsbereich 0 V bis 0,6 V jedoch einen linearen, d. h. nahezu ohmschen Verlauf. Diese Struktur kann somit bei Anliegen einer Spannung mit Vorwärtsrichtung nicht als elektrisch sperrend bezeichnet werden und weist somit nicht die gewünschte Funktionalität einer Bypassdiode auf. Dies bestätigt experimentell die zuvor angegebene vorzugsweise Ausführungsform mit einer Obergrenze für den Gehalt an Fritte in der Paste bei Herstellung der Kontaktierungsstruktur.

Die mit c) gekennzeichnete Strom-Spannungskennlinie zeigt das Messergebnis einer Teststruktur, bei der wie auch bei der ersten Teststruktur Bleioxid mit einem Anteil kleiner 1 % enthalten ist. Zusätzlich ist bei dieser Teststruktur jedoch zwischen Halbleiter und Silber-Siebdruckpaste eine elektrisch isolierende Siliziumnitridschicht mit einer Dicke von 80 nm angeordnet. Hierdurch bildet sich ein Metall-Isolator-Halbleiterkontakt aus. Hierbei durchgreift die Metallisierung punktweise die isolierende Siliziumnitridschicht, so dass sich, trotz des Vorhandenseins der Siliziumnitridschicht ein Metall-Halbleiterkontakt mit Diodencharakter ausbildet.

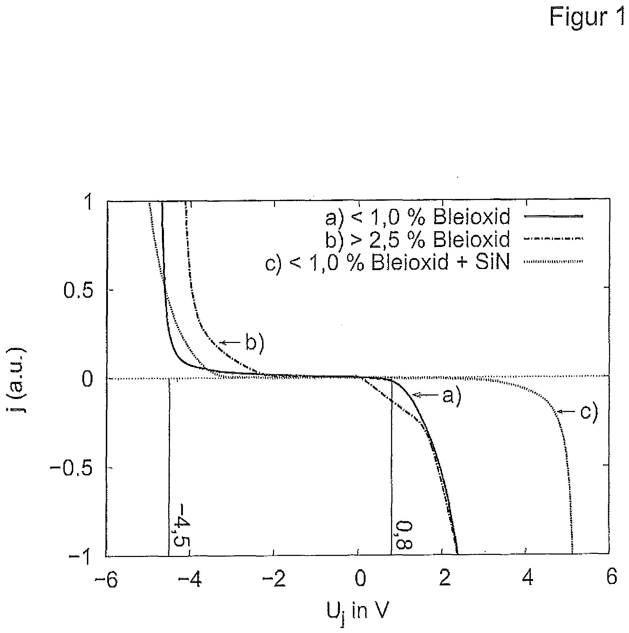

Wie in Figur 1 ersichtlich, weist diese Struktur den Vorteil auf, dass insbesondere bei in Vorwärtsrichtung anliegenden Spannungen (positive Spannungswerte) eine erheblich bessere Sperrwirkung erzielt wird. Darüber hinaus erfolgt bei in Sperrrichtung anliegender Spannung (negative Spannungswerte) bereits früher, d. h. bereits bei Spannungswerten von etwa -3,5 V ein erheblicher Stromfluss, verglichen mit der Strom-Spannungskennlinie a).

Aufgrund der vorliegenden Oberflächendotierkonzentration ergibt sich bei der Teststruktur somit ein Metall-Halbleiterkontakt mit einem gewünschten diodenartigen Charakter. In einem gleichen Prozessschritt können bei Vorliegen einer höheren Oberflächendotierung an der Oberfläche des Halbleiters mit ansonsten gleichen Parametern Ohmsche Kontakte, insbesondere zur Kontaktierung eines Emitter- oder eines Basisbereiches erzeugt werden. Die Ausbildung des Ohmschen Kontakts ist im Unterschied zu der vorgenannten Teststruktur insbesondere in der höheren Konzentration an Dotierstoff (n- oder p-Dotierstoff) an der der Metallisierung zugewandten Oberfläche des Halbleiters begründet.

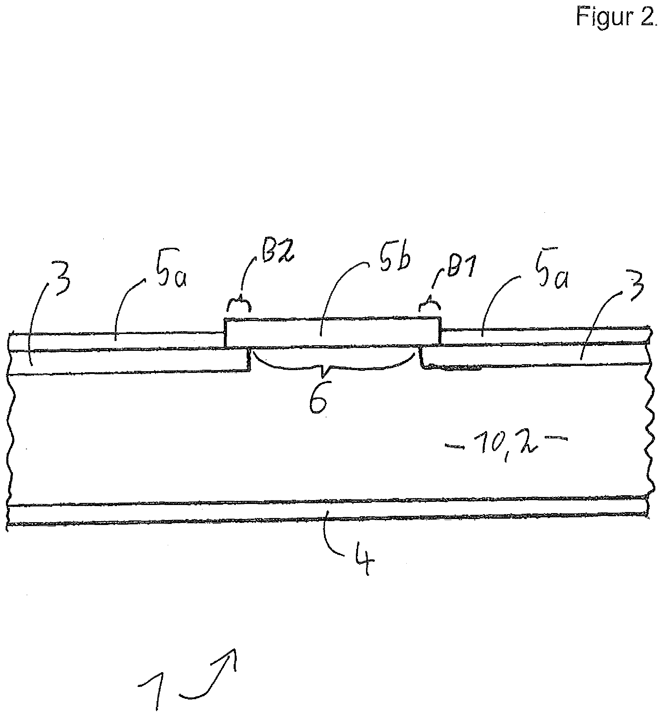

Figur 2 zeigt schematisch einen Teilausschnitt eines ersten Ausführungsbeispiels einer erfindungsgemäßen Solarzelle 1 in vereinfachter Darstellung. In den Figuren 2 bis 4 setzen sich die Solarzellen jeweils nach rechts und links fort.

Die Solarzelle 1 gemäß Figur 2 ist aus einem Siliziumsubstrat 1 aus multikristallinem Silizium hergestellt. Das Siliziumsubstrat 1 ist p-dotiert und stellt die Basis 2 der Solarzelle dar.

An der bei Betrieb der Solarzelle dem Lichteinfall zugewandten in Figur 2 oben dargestellten Vorderseite der Solarzelle 1 ist bereichsweise ein Emitter 3 mittels Diffusion eines n-Dotierungsstoffes, in diesem Fall Phospor, hergestellt. Der Emitter ist in an sich bekannter Weise erzeugt und weist einen Schichtwiderstand von 75 Ohm/square auf.

Die Rückseite der Solarzelle ist ganzflächig mittels einer metallischen Basiskontaktierungsstruktur 4, welche als Metallschicht ausgebildet ist, bedeckt.

Die vorderseitige Kontaktierung des Emitters erfolgt in an sich bekannter Weise mittels einer gitterartigen metallischen Kontaktierungsstruktur.

Wesentlich ist, dass die Emitterkontaktierungsstruktur 5 zweiteilig ausgebildet ist:
Bei Diffusion des Emitters 3 wurde in einem Überlappungsbereich 6 die Diffusion des Emitters vermieden. Dies wurde dadurch erzielt, dass vor der Diffusion in diesem Bereich eine Siliziumoxidschicht als Diffusionsbarriere aufgebracht wurde.

In dem Überlappungsbereich 6 befindet sich somit an der Vorderseite des Siliziumsubstrats 10 kein Emitter, stattdessen liegt im Überlappungsbereich ein Halbleiter mit der p-Dotierung der Basis 2 vor.

Die Emitterkontaktierungsstruktur 5 wurde zweiteilig erzeugt: in einem Teilbereich 5a wurde in an sich bekannter Weise per Siebdruck eine Emitterkontaktierungsstruktur in Form einer Silber-Siebdruckpaste zur Kontaktierung des Emitters 3 aufgebracht.

Zusätzlich wurde ein Teilbereich 5b der Emitterkontaktierungsstruktur mittels Aufbringen einer Silber-Siebdruckpaste mit verringerter Bleioxidkonzentration erzeugt.

Bei einem Kontaktfeuerungsschritt wird somit einerseits ein elektrischer Kontakt zwischen dem Teilbereich 5a der Emitterkontaktierungsstruktur 5 und dem Emitter 3 erzeugt, ebenso wird ein diodenartiger Metall-Halbleiterkontakt zwischen dem Teilbereich 5b der Emitterkontaktierungsstruktur und der Basis 2 in den Überlappungsbereich 6 erzeugt. Dieser diodenartige Halbleiterkontakt weist eine Diodenkennlinie gemäß Kennlinie a) in Figur 1 auf.

Auf diese Weise ist durch lediglich geringfügige Erweiterung des Herstellungsverfahrens eine Solarzelle geschaffen, welche zusätzlich die Funktionalität einer Bypassdiode aufgrund des diodenartigen Halbleiterkontakts im Überlappungsbereich 6 aufweist.

Sofern die Emitterkontaktierungsstruktur mehrteilig ausgebildet ist, wie beispielsweise in Figur 2 dargestellt, ist es vorteilhaft, dass derjenige Teilbereich der Emitterkontaktierungsstruktur, welcher den Überlappungsbereich überdeckt, zumindest geringfügig in die an den Überlappungsbereich 6 angrenzenden Bereiche hineinragt. In dem in Figur 2 dargestellten ersten Ausführungsbeispiel überdeckt der Teilbereich 5b der Emitterkontaktierungsstruktur 5 in den Bereichen B1 und B2 den Emitter 3. Dies hat folgenden Hintergrund:
Aufgrund der Zusammensetzung des Teilbereichs 5a der Emitterkontaktierungsstruktur 5 würde ein hohes Risiko bestehen, dass ein Ohmscher Kontakt zwischen Emitterkontaktierungsstruktur und Basis und damit ein Shunt (d.h. ein Kurzschluss mit ohmschen Charakter) entsteht, sofern der Teilbereich 5a der Emitterkontaktierungsstruktur 5 unmittelbar einen p-dotierten Basisbereich, wie beispielsweise den Überlappungsbereich 6 überdecken würde.

Durch die zumindest geringfügige Überdeckung der Emitter 3 an den Grenzbereichen durch den Teilbereich 5b der Emitterkontaktierungsstruktur 5 wird das Risiko einer solchen Shuntbildung, die zu erheblichen Wirkungsgradverlusten führen würde, erheblich verringert, eine Shuntbildung in diesem Bereich ist nahezu ausgeschlossen.
Vorzugsweise beträgt die Breite der Überlappungsbereiche B1 und B2 mindestens 50 µm.

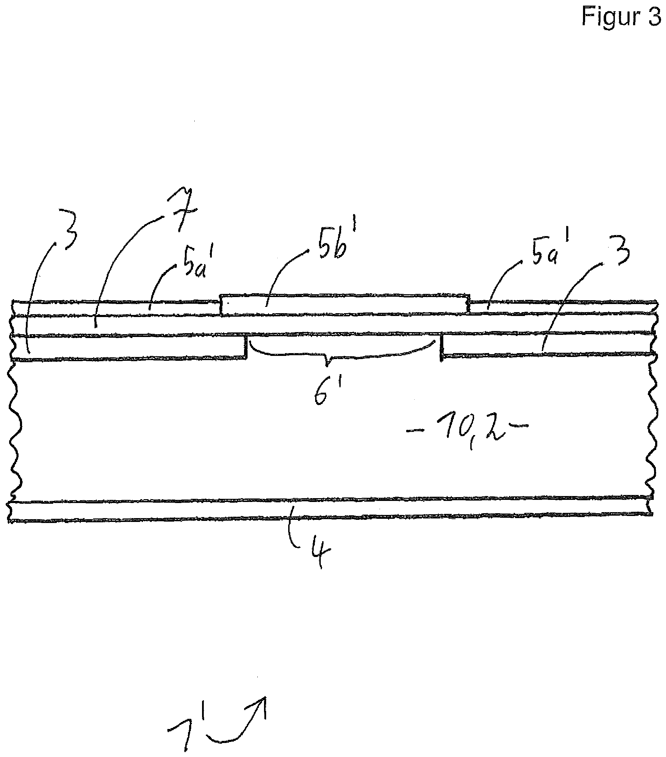

In Figur 3 ist ein zweites Ausführungsbeispiel einer erfindungsgemäßen Solarzelle 1' dargestellt:
Der Aufbau gleicht hinsichtlich Siliziumsubstrat 10, Basis 2, Emitter 3 und Basiskontaktierungsstruktur 4 dem Aufbau des ersten Ausführungsbeispiels gemäß Figur 2.
Die Ausbildung des diodenartigen Halbleiterkontakts wurde in diesem zweiten Ausführungsbeispiel dadurch realisiert, dass auf der Vorderseite in an sich üblicher Weise die Emitterkontaktierung mittels Aufbringen von Metallisierungsfingern ausgebildet wurde, welche Metallisierungsfinger in an sich bekannter Weise mittels eines Busbars verbunden sind. In diesem zweiten Ausführungsbeispiel wurden der Überlappungsbereich 6' unter dem Busbar 5b' liegend ausgebildet. Der Busbar wurde mittels Silber-Siedruckpaste erzeugt. Zuvor wurde eine als Siliziumnitridschicht ausgebildete Antireflexschicht 7 in an sich bekannter Weise mit einer Dicke von 80 nm ganzflächig auf die Vorderseite des Siliziumsubstrates 10 aufgebracht. Nach Kontaktfeuern bildet sich somit in dem Überlappungsbereich 6' ein Metall-Halbleiterkontakt aus, der eine Strom-Spannungskennlinie gemäß Kennlinie c) in Figur 1 aufweist. Wie zuvor beschrieben, bildet sich beim Kontaktfeuern trotz des Vorhandenseins der Antireflexschicht 7 ein Metall-Halbleiterkontakt mit Diodencharakter in dem Überlappungsbereich 6' aus, da das Metall beim Kontaktfeuern die Antireflexschicht 7 teilweise (insbesondere punktuell) durchgreift.
Darüber hinaus wirkt die Antireflexschicht 7 reflexionsvermindernd hinsichtlich des Lichteinfalls an der in Figur 3 oben liegenden Vorderseite der Solarzelle 1, so dass zusätzlich die Lichteinkopplung erhöht wird.

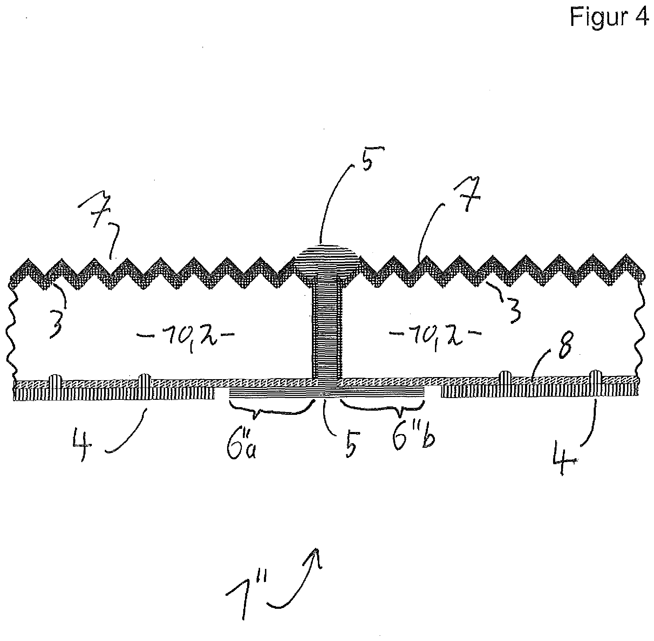

In Figur 4 ist ein drittes Ausführungsbeispiel einer Solarzelle 1", die nicht Teil der Erfindung ist, ebenfalls als Teilausschnitt in schematischer Darstellung gezeigt. Die Solarzelle basiert auf der an sich bekannten MWT-Solarzellenstruktur, wie beispielsweise in US 6,384,317 B1 beschrieben.

Bei einer solchen Solarzellenstruktur ist die Emitterkontaktierungsstruktur 5 von der Vorderseite mittels Ausnehmungen in der Solarzelle zur Rückseite geführt, so dass an der Rückseite sowohl die Emitterkontaktierungsstruktur 5, als auch die Basiskontaktierungsstruktur 4 kontaktierbar ist. Die MWT-Solarzelle ist somit eine einseitig kontaktierbare Solarzelle.

An der Vorderseite ist eine pyramidenartige Strukturierung sowie eine Antireflexschicht 7 zur Erhöhung der Lichteinkopplung bei auf die in Figur 4 oben liegende Vorderseite der Solarzelle ausgebildet. Ebenso ist ein Emitter 3 an der Vorderseite der Solarzelle 1" ausgebildet.

An der Rückseite des Siliziumsubstrats 10, welches ebenfalls zur Ausbildung der Basis 2 p-dotiert ist, ganzflächig eine Schichtsystem aus Aluminiumoxid und Siliciumnitrid 8 aufgebracht.

Dieses Schichtsystem ist in den Bereichen der Basiskontaktierungsstruktur 4 punktweise mittels des an sich bekannten LFC-Verfahrens (wie in US 6982218 bzw. WO 02/25742 beschrieben) durchbrochen, so dass an diesen lokalen Punkten lokale elektrische Kontakte zwischen Basiskontaktierungsstruktur 4 und Basis 2 bestehen.

Wesentlich ist, dass sich in Überlappungsbereichen 6"a und 6"b ein diodenartiger Metall-Halbleiterkontakt zwischen Emitterkontaktierungsstruktur 5 und Basis 2 ausgebildet ist.

Auch bei der an sich bekannten MWT-Struktur kann somit durch geringfügige Änderung des Herstellungsprozesses eine MWT-Solarzelle erzeugt werden, welche die Funktionalität einer Bypassdiode zusätzlich aufweist.

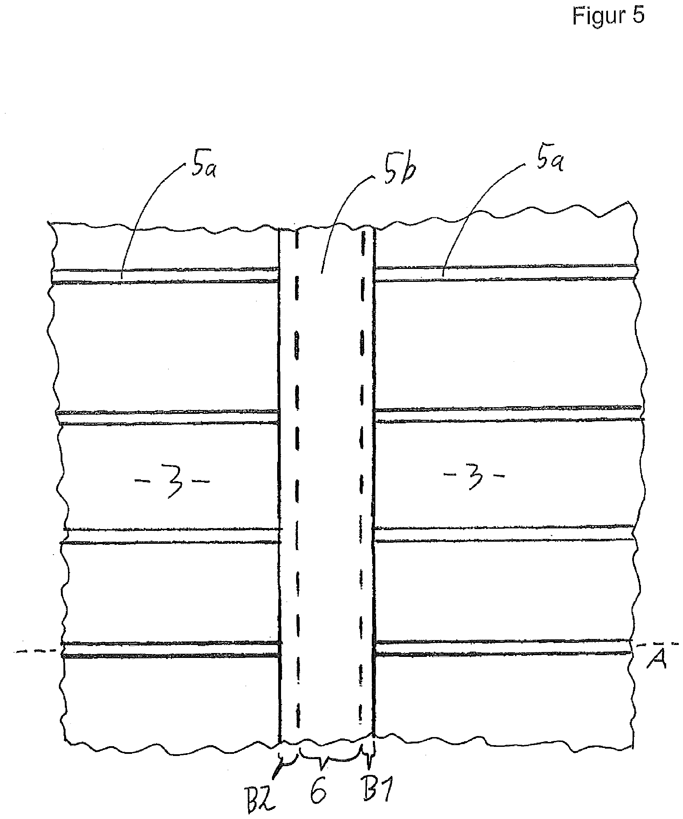

Figur 5 zeigt eine Draufsicht von oben auf eine Solarzelle gemäß Figur 2, wobei auch Figur 5 einen Teilausschnitt und eine schematische Darstellung zeigt.

In Figur 5 ist ersichtlich, dass die Vorderseite der Solarzelle ein doppelkammartiges Kontaktierungsgitter in an sich bekannter Form aufweist, welches die als Kontaktierungsfinger ausgebildeten Teilbereiche 5a und den als Busbar ausgebildeten Teilbereich 5b umfasst. Der Busbar 5b überdeckt den Überlappungsbereich 6 vollständig und überdeckt darüber hinaus in den Bereichen B1 und B2 den Emitterbereich 3 der Solarzelle.

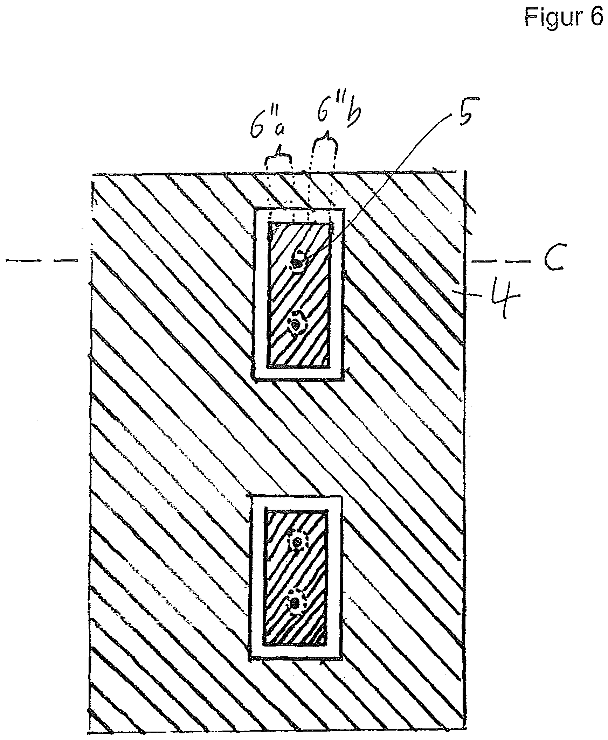

Figur 6 zeigt eine Rückansicht einer Solarzelle gemäß Figur 4. Auch Figur 6 zeigt eine Teilausschnitt und eine schematische Darstellung.

Figur 4 ist eine Schnittdarstellung gemäß Schnittlinie C und senkrecht zur Zeichenebene in Figur 6.

Wie in Figur 6 ersichtlich und wie bei MWT-Solarzellen üblich, ist die Rückseite im Wesentlichen durch die Basismetallisierungskontaktierungsstruktur 4 bedeckt. In inselartigen Ausnehmungen ist die Emitterkontaktierungsstruktur 5 angeordnet, bei welcher zum besseren Verständnis zusätzlich die Metallisierung in den lochartigen Ausnehmungen gekennzeichnet ist. Weiterhin sind in Figur 6 die Überlappungsbereiche 6"a und 6"b gemäß Figur 4 angegeben.

Weitere vorzugsweisen Ausführgsformen sind nachfolgend mit Bezugnahme auf die Bezugszeichen der Figuren ausgeführt:
Die erfindungsgemäße Solarzelle zeichnet sich vorzugsweise durch eine oder mehrere der nachfolgenden vorteilhaften Ausgestaltungen aus,
   - dass zumindest im Überlappungsbereich (6, 6', 6"a, 6"b) die metallische Kontaktstruktur einen Anteil an Glasfritte kleiner 5 %, bevorzugt kleiner 2 %, weiter bevorzugt 1 %, insbesondere keine Glasfritte aufweist;
   - dass im Überlappungsbereich (6, 6', 6"a, 6"b) die Dotierstoffkonzentration im Halbleiter an der der metallischen Kontaktierungsstruktur zugewandten Oberfläche kleiner 10¹⁹ cm⁻³, bevorzugt kleiner 10¹⁸ cm⁻³, bevorzugt kleiner 10¹⁷ cm⁻³ ist;
   - dass in dem Emitterbypassbereich die Emitterkontaktierungsstruktur (5) eines oder mehrere Metalle der Gruppe Silber, Aluminium, Titan, Palladium, Zink, Platin, Nickel, Zinn, Blei, Kobalt, Wolfram und Bismut umfasst;
   - dass zumindest im Überlappungsbereich (6, 6', 6"a, 6"b) die Kontaktierungsstruktur als Schichtsystem ausgebildet ist, wobei zwischen Halbleiter und einer metallischen Schicht mindestens eine Zwischenschicht ausgebildet ist, vorzugsweise eine Zwischenschicht umfassend Siliziumnitrid und/oder Aluminiumoxid und/oder Siliziumoxid, um die elektrische Isolationswirkung im Überlappungsbereich (6, 6', 6"a, 6"b) bei Anliegen einer Spannung in Vorwärtsrichtung zu verbessern;
   - dass die Halbleiteroberfläche zumindest im Überlappungsbereich (6, 6', 6"a, 6"b) plan ist;
   - dass die Solarzelle eine MWT-Solarzelle ist, welche mindestens eine, vorzugsweise eine Mehrzahl metallischer Durchkontaktierungen von einer Vorder- zu einer Rückseite der Solarzelle aufweist und
      dass der Überlappungsbereich (6"a, 6"b) an der Rückseite ausgebildet ist und vorzugsweise zumindest in einem Teilbereich des Überlappungsbereiches ein diodenartiger Halbleiterkontakt zwischen Emitterkontaktierungsstruktur (5) und Basisbereich ausgebildet ist, welcher Halbleiterkontakt als Metall-Halbleiterkontakt ausgebildet ist.
   - dass die Halbleiteroberfläche zumindest im Überlappungsbereich (6, 6', 6"a, 6"b) plan ist;
   - dass die Solarzelle eine MWT-Solarzelle ist, welche mindestens eine, vorzugsweise eine Mehrzahl metallischer Durchkontaktierungen von einer Vorder- zu einer Rückseite der Solarzelle aufweist und
      dass der Überlappungsbereich (6"a, 6"b) an der Rückseite ausgebildet ist und vorzugsweise zumindest in einem Teilbereich des Überlappungsbereiches ein diodenartiger Halbleiterkontakt zwischen Emitterkontaktierungsstruktur (5) und Basisbereich ausgebildet ist, welcher Halbleiterkontakt als Metall-Halbleiterkontakt ausgebildet ist.

## Patentansprüche

1. Photovoltaische Solarzelle (1, 1') zur Umwandlung einfallender elektromagnetischer Strahlung in elektrische Energie, umfassend
- mindestens einen in einem Siliziumsubstrat (10) ausgebildeten Basisbereich eines Basisdotierungstyps,
- mindestens einen Emitterbereich eines Emitterdotierungstyps, welcher Emitterdotierungstyp ein zu dem Basisdotierungstyp entgegengesetzter Dotierungstyp ist,
- mindestens eine metallische Basiskontaktierungsstruktur (4), welche Basiskontaktierungsstruktur (4) elektrisch leitend mit dem Basisbereich verbunden ist und
- mindestens eine metallische Emitterkontaktierungsstruktur (5), welche Emitterkontaktierungsstruktur (5) elektrisch leitend mit dem Emitterbereich verbunden ist,
wobei Basisbereich und Emitterbereich derart angeordnet sind, dass sich zwischen Basis- und Emitterbereich zumindest bereichsweise ein pn-Übergang ausbildet,
**dadurch gekennzeichnet,**
**dass** in einem Emitterbypassbereich, in dem sich kein Emitter befindet, die Emitterkontaktierungsstruktur (5) den Basisbereich überlappt und in diesem Überlappungsbereich (6, 6') zumindest in einem Teilbereich des Überlappungsbereichs ein diodenartiger Halbleiterkontakt zwischen Emitterkontaktierungsstruktur (5) und Basisbereich ausgebildet ist, welcher Halbleiterkontakt als Schottky-Metall-Halbleiterkontakt ausgebildet ist.

2. Solarzelle (1, 1') nach Anspruch 1, dass der diodenartige Halbleiterkontakt in dem Überlappungsbereich (6, 6') zumindest bei einer an den metallischen Kontaktstrukturen anliegenden Rückwärtsspannung betragsmäßig größer 5 V vorzugsweise betragsmäßig größer 3 V in Rückwärtsrichtung elektrisch leitend ausgebildet ist, vorzugsweise mit einer Stromflussdichte größer 100 mA/cm², bevorzugt größer 500 mA/cm², weiter bevorzugt größer 2000 mA/cm².

3. Solarzelle (1, 1') nach einem der vorangegangenen Ansprüche, **dadurch gekennzeichnet,**
**dass** der diodenartige Halbleiterkontakt bei einer an den metallischen Kontaktstrukturen anliegenden Vorwärtsspannung im Bereich 0 V bis 0,5 V, vorzugsweise 0 V bis 0,6 V, elektrisch sperrend ausgebildet ist, vorzugsweise mit einer Stromflussdichte in diesem Spannungsbereich kleiner 10 mA/cm², bevorzugt kleiner 1 mA/cm², weiter bevorzugt kleiner 0,1 mA/cm² ausgebildet ist.

4. Solarzelle (1, 1') nach einem der vorangegangenen Ansprüche, **dadurch gekennzeichnet,**
**dass** ein oder mehrere Überlappungsbereiche ausgebildet sind und die Gesamtfläche des oder der Überlappungsbereiche größer 0,5 %, bevorzugt größer 2 % im Weiteren bevorzugt größer 5 % der Gesamtfläche der der Solarzelle (1, 1', 1") ist.

5. Solarzellenmodul, umfassend eine oder mehrere Solarzellen gemäß einem der vorangegangenen Ansprüche, welche Solarzellen in Reihen- und/oder Parallelschaltung miteinander elektrisch verbunden sind,
wobei das Solarzellenmodul keine Bypassdiode aufweist, abgesehen von dem oder den integralen diodenartigen Halbleiterkontakten der Solarzellen gemäß einem der vorangehenden Ansprüche.

6. Verfahren zur Herstellung einer photovoltaischen Solarzelle (1, 1'), gemäß einem der vorangehenden Ansprüche,
folgende Verfahrensschritte umfassend
- Bereitstellen eines Siliziumsubstrats mit einem in dem Siliziumsubstrat ausgebildeten Basisbereich eines Basisdotierungstyps,
- Ausbilden eines Emitterbereichs in oder an dem Siliziumsubstrat (10), welcher Emitterbereich mit einem dem Basisdotierungstyp entgegengesetzten Emitterdotierungstyp ausgebildet wird, so dass sich zwischen Basis- und Emitterbereich zumindest bereichsweise ein pn-Übergang ausbildet,
- Aufbringen einer metallischen Basiskontaktierungsstruktur (4), welche Basiskontaktierungsstruktur (4) elektrisch leitend mit dem Basisbereich verbunden ist und
- Aufbringen mindestens einer metallischen Emitterkontaktierungsstruktur (5), welche Emitterkontaktierungsstruktur (5) elektrisch leitend mit dem Emitterbereich verbunden ist,
**dadurch gekennzeichnet,**
**dass** in einem Emitterbypassbereich, in dem sich kein Emitter befindet, die Emitterkontaktierungsstruktur (5) den Basisbereich überlappend aufgebracht wird und in diesem Überlappungsbereich (6, 6') ein diodenartiger Schottky-Metall-Halbleiterkontakt zwischen Emitterkontaktierungsstruktur (5) und Basisbereich ausgebildet ist.

7. Verfahren nach Anspruch 6, **dadurch gekennzeichnet, dass** zumindest in Teilbereichen des Überlappungsbereiches (6, 6') die Kontaktierungsstruktur mittels Siebdruck aufgebracht wird, vorzugsweise durch Aufbringen einer silberhaltigen Siebdruckpaste; oder
dass zumindest in Teilen des Überlappungsbereichs (6, 6') die Kontaktierungsstruktur mittels kontaktloser Druckverfahren, vorzugsweise Inkjetdruck oder Aerosoldruck, erzeugt wird.

8. Verfahren nach Anspruch 7, **dadurch gekennzeichnet, dass** die Metallpaste bzw. -tinte Fritte mit einem Anteil im Bereich von 0,1 % bis 2 %, bevorzugt im Bereich von 0,1 % bis 1 % enthält, insbesondere, dass die Metallpaste bzw. -tinte Bleiglasfritte und/oder Zinkglasfritte und/oder Bismutborglasfritte enthält.

9. Verfahren nach einem der Ansprüche 7 bis 8, **dadurch gekennzeichnet, dass** die Metallpaste bzw. -tinte eines oder mehrere Oxide enthält, vorzugsweise eines oder mehrere Oxide aus der Gruppe GeO₂, P₂O₅, Na₂O, K₂O, CaO, Al₂O₃, MgO, TiO₂, B₂O₃.

10. Verfahren nach Anspruch 6, **dadurch gekennzeichnet, dass** zumindest in Teilen des Überlappungsbereichs (6, 6') die Kontaktierungsstruktur mittels physikalischer Gasphasenabscheidung, vorzugsweise Bedampfen, erzeugt wird.

11. Verfahren nach einem der Ansprüche 6 bis 10, **dadurch gekennzeichnet, dass** nach Aufbringen der Kontaktierungsstruktur im Überlappungsbereich (6, 6') ein Kontaktfeuerschritt durchgeführt wird, vorzugsweise bei einer Temperatur im Bereich 500°C bis 1000°C, weiter bevorzugt im Bereich 800°C bis 900°C.

12. Verfahren nach einem der Ansprüche 6 bis 11, **dadurch gekennzeichnet, dass** der Emitter (3) mittels Diffusion in dem Siliziumsubstrat (10) ausgebildet wird und
dass im Überlappungsbereich (6, 6') zwischen Kontaktierungsstruktur und Basisbereich ein diodenartiger Halbleiterkontakt ausgebildet wird, indem bei Diffusion des Emitters im Überlappungsbereich (6, 6') mittels einer Maskierung eine Diffusion verhindert wird oder dass nach Diffusion des Emitters im Überlappungsbereich (6, 6') der Emitter (3) wieder entfernt wird, vorzugsweise mittels Rückätzen.

## Claims

1. Photovoltaic solar cell (1, 1') for converting incident electromagnetic radiation into electrical energy, comprising
- at least one base region of a base-doping type formed in a silicon substrate (10),
- at least one emitter region of an emitter-doping type, which emitter-doping type is a doping type opposite to the base-doping type,
- at least one metallic base contacting structure (4), which base contacting structure (4) is electrically conductively connected to the base region and
- at least one metallic emitter contacting structure (5), which emitter contacting structure (5) is electrically conductively connected to the emitter region,
wherein the base region and the emitter region are arranged in such a way that, at least in some regions, a pn-junction is formed between the base and emitter regions,
**characterised in that**
in an emitter bypass region, in which there is no emitter, the emitter contacting structure (5) overlaps the base region and **in that** overlapping region (6, 6'), at least in a sub-region of the overlapping region, a diode-like semiconductor contact is formed between the emitter contacting structure (5) and the base region, which semiconductor contact is in the form of a Schottky metal-semiconductor contact.

2. Solar cell (1, 1') according to claim 1,
**characterised in that**
the diode-like semiconductor contact in the overlapping region (6, 6'), at least when a reverse voltage of a magnitude greater than 5 V, preferably of a magnitude greater than 3 V, is applied to the metallic contact structures, is configured so as to be electrically conductive in the reverse direction, preferably with a current flow density greater than 100 mA/cm², preferably greater than 500 mA/cm², more preferably greater than 2000 mA/cm².

3. Solar cell (1, 1') according to either one of the preceding claims,
**characterised in that**
the diode-like semiconductor contact, when a forward voltage in the range of from 0 V to 0.5 V, preferably from 0 V to 0.6 V, is applied to the metallic contact structures, is configured so as to be electrically blocking, preferably with a current flow density **in that** voltage range of less than 10 mA/cm², preferably less than 1 mA/cm², more preferably less than 0.1 mA/cm².

4. Solar cell (1, 1') according to any one of the preceding claims,
**characterised in that**
one or more overlapping regions are formed and the total surface area of the overlapping region(s) is greater than 0.5 %, preferably greater than 2 %, more preferably greater than 5 %, of the total surface area of the solar cell (1, 1', 1").

5. Solar cell module, comprising one or more solar cells according to any one of the preceding claims, which solar cells are electrically connected to one another in series and/or in parallel,
wherein the solar cell module has no bypass diode, apart from the integral diode-like semiconductor contact(s) of the solar cells according to any one of the preceding claims.

6. Method for producing a photovoltaic solar cell (1, 1') according to any one of the preceding claims, comprising the following method steps:
- provision of a silicon substrate having a base region of a base-doping type formed in the silicon substrate,
- formation of an emitter region in or on the silicon substrate (10), which emitter region is formed with an emitter-doping type opposite to the base-doping type, so that, at least in some regions, a pn-junction is formed between the base and emitter regions,
- application of a metallic base contacting structure (4), which base contacting structure (4) is electrically conductively connected to the base region and
- application of at least one metallic emitter contacting structure (5), which emitter contacting structure (5) is electrically conductively connected to the emitter region,
**characterised in that**
in an emitter bypass region, in which there is no emitter, the emitter contacting structure (5) is applied to as to overlap the base region, and **in that** overlapping region (6, 6') a diode-like Schottky metal-semiconductor contact is formed between the emitter contacting structure (5) and the base region.

7. Method according to claim 6,
**characterised in that**
at least in sub-regions of the overlapping region (6, 6') the contacting structure is applied by means of screen printing, preferably by application of a silver-containing screen-printing paste; or
at least in parts of the overlapping region (6, 6') the contacting structure is produced by means of contactless printing methods, preferably inkjet printing or aerosol printing.

8. Method according to claim 7,
**characterised in that**
the metal paste or metal ink contains frit in a proportion in the range of from 0.1 % to 2 %, preferably in the range of from 0.1 % to 1 %, the metal paste or metal ink especially containing lead glass frit and/or zinc glass frit and/or bismuth-boron glass frit.

9. Method according to either one of claims 7 and 8,
**characterised in that**
the metal paste or metal ink contains one or more oxides, preferably one or more oxides from the group GeO₂, P₂O₅, Na₂O, K₂O, CaO, Al₂O₃, MgO, TiO₂, B₂O₃.

10. Method according to claim 6,
**characterised in that**
at least in parts of the overlapping region (6, 6') the contacting structure is produced by means of physical gas phase deposition, preferably vapour deposition.

11. Method according to any one of claims 6 to 10,
**characterised in that**
after application of the contacting structure in the overlapping region (6, 6') a contact firing step is carried out, preferably at a temperature in the range of from 500°C to 1000°C, more preferably in the range of from 800°C to 900°C.

12. Method according to any one of claims 6 to 11,
**characterised in that**
the emitter (3) is formed by means of diffusion in the silicon substrate (10) and
in the overlapping region (6, 6') a diode-like semiconductor contact is formed between the contacting structure and the base region, wherein, during diffusion of the emitter, diffusion is prevented in the overlapping region (6, 6') by means of masking, or
after diffusion of the emitter, the emitter (3) is removed again in the overlapping region (6, 6'), preferably by means of etchback.

## Revendications

1. Cellule solaire photovoltaïque (1, 1') pour convertir un rayonnement électromagnétique incident en énergie électrique, comprenant
- au moins une région de base d'un type de dopage de base réalisée dans un substrat de silicium (10),
- au moins une région d'émetteur d'un type de dopage d'émetteur, lequel type de dopage d'émetteur présente un type de dopage opposé au type de dopage de base,
- au moins une structure de contact de base (4) métallique, laquelle structure de contact de base (4) est reliée de façon électriquement conductrice à la région de base et
- au moins une structure de contact d'émetteur (5) métallique, laquelle structure de contact d'émetteur (5) est reliée de façon électriquement conductrice à la région d'émetteur,
dans laquelle la région de base et la région d'émetteur sont disposées de sorte qu'une jonction pn soit réalisée au moins par endroits entre la région de base et la région d'émetteur,
**caractérisée en ce**
**que** la structure de contact d'émetteur (5) recouvre la région de base dans une région de dérivation d'émetteur dans laquelle aucun émetteur ne se trouve et qu'un contact semiconducteur du type diode est réalisé dans cette région de recouvrement (6, 6'), au moins dans une partie de la région de recouvrement, entre la structure de contact d'émetteur (5) et la région de base, lequel contact semiconducteur est réalisé sous la forme d'un contact semiconducteur-métal Schottky.

2. Cellule solaire (1, 1') selon la revendication 1,
**caractérisée en ce**
**que** le contact semiconducteur du type diode dans la région de recouvrement (6, 6') est conçu électriquement conducteur au moins pour une tension inverse appliquée aux structures de contact métalliques supérieure en amplitude à 5 V, de préférence supérieure en amplitude à 3 V en sens inverse, de préférence avec une densité de courant supérieure à 100 mA/cm², de préférence supérieure à 500 mA/cm², plus préférentiellement supérieure à 2 000 mA/cm².

3. Cellule solaire (1, 1') selon l'une des revendications précédentes,
**caractérisée en ce**
**que** le contact semiconducteur du type diode est conçu électriquement bloquant pour une tension directe appliquée aux structures de contact métalliques dans la plage de 0 V à 0,5 V, de préférence de 0 V à 0,6 V, de préférence avec une densité de courant dans cette plage de tension inférieure à 10 mA/cm², de préférence inférieure à 1 mA/cm², plus préférentiellement inférieure à 0,1 mA/cm².

4. Cellule solaire (1, 1') selon l'une des revendications précédentes,
**caractérisée en ce**
**qu'**une ou plusieurs régions de recouvrement sont réalisées et la surface totale de la ou des région(s) de recouvrement est supérieure à 0,5 %, de préférence supérieure à 2 %, plus préférentiellement supérieure à 5 % de la surface totale de la cellule solaire (1, 1', 1").

5. Module solaire,
comprenant une ou plusieurs cellules solaires selon l'une des revendications précédentes, lesquelles cellules solaires sont reliées entre elles électriquement en série et/ou en parallèle,
lequel module solaire ne présente pas de diode de dérivation en dehors du ou des contact(s) semiconducteur(s) du type diode intégré(s) dans les cellules solaires selon l'une des revendications précédentes.

6. Procédé de fabrication d'une cellule solaire photovoltaïque (1, 1') selon l'une des revendications précédentes,
comprenant les étapes suivantes :
- mise à disposition d'un substrat de silicium avec une région de base d'un type de dopage de base réalisé dans le substrat de silicium,
- réalisation d'une région d'émetteur dans ou sur le substrat de silicium (10), laquelle région d'émetteur est réalisée avec un type de dopage d'émetteur opposé au type de dopage de base, de sorte qu'une jonction pn est réalisée au moins par endroits entre la région de base et la région d'émetteur,
- application d'une structure de contact de base (4) métallique, laquelle structure de contact de base (4) est reliée de façon électriquement conductrice à la région de base et
- application d'au moins une structure de contact d'émetteur (5) métallique, laquelle structure de contact d'émetteur (5) est reliée de façon électriquement conductrice à la région d'émetteur,
**caractérisé en ce**
**que** la structure de contact d'émetteur (5) est appliquée de façon à recouvrir la région de base dans une région de dérivation d'émetteur dans laquelle aucun émetteur ne se trouve et qu'un contact semiconducteur-métal Schottky du type diode est réalisé dans cette région de recouvrement (6, 6') entre la structure de contact d'émetteur (5) et la région de base.

7. Procédé selon la revendication 6,
**caractérisé en ce**
**qu'**au moins dans des parties de la région de recouvrement (6, 6'), la structure de contact est appliquée par sérigraphie, de préférence par application d'une pâte de sérigraphie contenant de l'argent ;
ou
**qu'**au moins dans des parties de la région de recouvrement (6, 6'), la structure de contact est produite au moyen d'un procédé d'impression sans contact, de préférence par impression à jet d'encre ou impression à jet d'aérosol.

8. Procédé selon la revendication 7,
**caractérisé en ce**
**que** la pâte ou l'encre métallique contient une fritte dans une proportion se situant dans la plage de 0,1 % à 2 % , de préférence dans la plage de 0,1 % à 1 %, en particulier que la pâte ou l'encre métallique contient une fritte de verre au plomb et/ou une fritte de verre au zinc et/ou une fritte de verre au bismuth et au bore.

9. Procédé selon l'une des revendications 7 à 8,
**caractérisé en ce**
**que** la pâte ou l'encre métallique contient un ou plusieurs oxydes, de préférence un ou plusieurs oxydes choisis dans le groupe constitué par Ge02, P₂O₅, Na₂O, K₂O, CaO, Al₂O₃, MgO, TiO₂, B₂O₃.

10. Procédé selon la revendication 6,
**caractérisé en ce**
**qu'**au moins dans des parties de la région de recouvrement (6, 6'), la structure de contact est produite par dépôt physique en phase gazeuse, de préférence par métallisation sous vide.

11. Procédé selon l'une des revendications 6 à 10,
**caractérisé en ce**
**qu'**après application de la structure de contact, une étape de formation d'un arc entre contacts est effectuée dans la région de recouvrement (6, 6'), de préférence à une température dans la plage de 500 °C à 1 000 °C, plus préférentiellement dans la plage de 800 °C à 900 °C.

12. Procédé selon l'une des revendications 6 à 11,
**caractérisé en ce**
**que** l'émetteur (3) est réalisé par diffusion dans le substrat de silicium (10) et qu'un contact semiconducteur du type diode est réalisé dans la région de recouvrement (6, 6') entre structure de contact et région de base en empêchant une diffusion dans la région de recouvrement (6, 6') au moyen d'un masquage lors de la diffusion de l'émetteur ou en supprimant de nouveau l'émetteur (3), de préférence par gravure en retrait, après diffusion de l'émetteur dans la région de recouvrement (6, 6').
